# DEMANDE DE BREVET EUROPEEN

(11) **EP 2 750 169 A2**
(43) Date de publication de la demande: **02.07.2014**
(21) Numéro de dépôt: 13199207.5
(22) Date de dépôt: 20.12.2013
(51) Int. Cl.: H01L 21/311, H01L 21/02

(54) **Procédé de gravure d'un matériau diélectrique poreux**

(30) Priorité: 28.12.2012 FR 1262910
(71) Demandeur: COMMISSARIAT A L'ENERGIE ATOMIQUE ET AUX ENERGIES ALTERNATIVES, 75015 Paris (FR); Centre National de la Recherche Scientifique, 75016 Paris (FR); Applied Materials, Inc., Santa Clara, CA 95050 (US)
(72) Inventeur: Posseme, Nicolas, 38000 GRENOBLE (FR); Barnola, Sébastien, 38190 VILLARD-BONNOT (FR); Joubert, Olivier, 38240 MEYLAN (FR); Nemani, Srinivas, Santa Clara, 95050 Californie, CA California (US); Vallier, Laurent, 38240 MEYLAN (FR)
(74) Mandataire: Hautier, Nicolas

(57) **Abrégé**

L'invention porte sur un procédé de gravure d'un motif dans une couche de matériau diélectrique poreux (140), comprenant :
la définition du motif dans un masque (120, 130) surmontant la couche de matériau diélectrique poreux (140),
au moins une gravure de la couche de matériau diélectrique poreux (140) à travers le masque (120, 130).

La gravure est réalisée dans un plasma formé par un mélange comprenant un gaz à base de silicium, en présence d'azote (N₂) ou d'oxygène (O₂) de manière à faire croître tout au long de la gravure une couche de passivation (112), au moins sur les flancs de la couche de matériau diélectrique poreux (140).

L'invention s'applique de manière particulièrement avantageuse à la formation de tranchées pour former des lignes d'interconnexion électrique.

## Description

### DOMAINE TECHNIQUE DE L'INVENTION

La présente invention concerne en général l'utilisation de matériaux diélectrique poreux à faible permittivité pour la réalisation d'interconnexions électriques dans les circuits intégrés et plus particulièrement un procédé de gravure amélioré de ces matériaux.

### ÉTAT DE LA TECHNIQUE

L'objectif constant de l'industrie de la microélectronique depuis des décennies est d'être capable de produire, à faible coût, des circuits intégrés (IC) toujours plus denses avec des performances toujours plus élevées. Depuis l'introduction dans les années passées des familles ou « noeuds » technologiques de dimensions décananométriques, c'est-à-dire s'exprimant en dizaines de nanomètres (nm = 10⁻⁹ mètre), on constate que la performance des circuits n'est plus essentiellement dépendante de la vitesse de commutation des éléments actifs, les transistors, comme cela a été longtemps le cas, mais dépend largement des délais de propagation des signaux sur les lignes d'interconnexion métalliques entre transistors.

La vitesse de propagation des signaux électriques sur les lignes d'interconnexion métalliques dépend de la résistance électrique (R) des lignes et de la capacité (C) entre lignes métalliques adjacentes formant une constante de temps (RC) qui s'oppose aux changements rapides des niveaux électriques que l'on veut propager. Pour augmenter la vitesse de commutation, et/ou obtenir une dissipation de puissance moindre des circuits, il faut donc diminuer cette constante de temps.

Dès la fin des années 90 une diminution significative de résistance électrique des lignes d'interconnexion a déjà été obtenue avec l'introduction du cuivre, en remplacement de l'aluminium, et de sa technologie dite de damasquinage ou damascène dans laquelle les lignes de cuivre sont incrustées dans le matériau diélectrique les séparant, essentiellement de l'oxyde de silicium (Si02) à l'origine. Pour les noeuds technologiques décananométriques l'amélioration apportée par l'utilisation du cuivre s'est cependant avérée être insuffisante et il a fallu envisager d'utiliser aussi des matériaux diélectriques à plus faible permittivité afin de réduire la constante de temps (RC) en diminuant cette fois la capacité.

Ainsi, dès l'introduction du noeud technologique de 90 nm l'oxyde de silicium (SiO₂), qui a une constante diélectrique (notée k, la constante diélectrique est la permittivité relative à celle de l'air du matériau considéré) de l'ordre de 4, a été remplacé par un oxyde basé sur l'utilisation du groupe méthyle (-CH3) associé au silicium (Si) pour former un composé diélectrique Si-CH3 et plus particulièrement l'oxyde modifié SiOCH dont la constante diélectrique est de l'ordre de 2,9. Plus généralement, il s'agit d'oxydes dopés au carbone et à l'hydrogène pour former des matériaux de type dit silsesquioxane de formule (R-Si03/2)n. Ils présentent une structure en forme de cage contenant huit atomes de silicium placés au sommet d'un cube. Le substituant -R peut être un groupe méthyle -CH3, on parle alors de méthyle silsesquioxane (MSQ), ou un atome d'hydrogène -H, on parle dans ce cas d'hydrogène silsesquioxane (HSQ).

Pour continuer à progresser dans cette direction, c'est-à-dire diminuer la permittivité du diélectrique de façon significative, l'approche retenue pour la mise en production du noeud technologique de 45 nm a consisté à rendre poreux le SiOCH qui est alors noté p-SiOCH. La formation de pores dans le matériau SiOCH permet de diminuer encore la constante diélectrique k jusqu'à atteindre des valeurs de l'ordre de 2,5 à 2,3 voire inférieures. On notera ici que ce type de matériau est alors qualifié dans la littérature technique du vocable anglais de « ultra low-k » ou encore ULK signifiant en français « permittivité ultra faible ».

Toutefois, la porosité du matériau ainsi obtenu crée des problèmes liés à une résistance mécanique moindre et à une susceptibilité importante à l'absorption d'humidité. L'incorporation des matériaux ULK dans les procédés technologiques pour la production des noeuds technologiques à partir de 45 nm ne manque donc pas de poser des problèmes, notamment de gravure du matériau poreux lors de la formation des interconnexions.

La plus grande sensibilité de ce type de diélectrique à la gravure se manifeste dans le procédé damascène qui est utilisé pour la mise en oeuvre du cuivre que l'on continue bien sûr d'employer pour bénéficier de la plus faible résistivité électrique de ce matériau. Dans le cadre de ce procédé, la gravure du matériau diélectrique est anisotrope. Le plasma est typiquement un plasma à base de produits fluorocarbonés de type C4F8, CF4, C4F6 ou CHF3.

Une des approches pour l'intégration du SiOCH poreux est l'utilisation de résines organiques comme masque pour la gravure. Cependant, après gravure du SiOCH, il est alors nécessaire de retirer la résine organique restante. Cette action de retrait organique est généralement qualifiée du terme anglais de « ashing » qui exprime le retrait des « cendres » restantes. Les chimies couramment utilisées pour ce retrait sont à base notamment d'oxygène et de nitrure d'hydrogène (NH3). Elles ont pour conséquences de modifier le SiOCH poreux en le transformant en Si02 ce qui génère une forte augmentation de la constante diélectrique et va directement à l'encontre du but recherché. À ces niveaux d'intégration, 45 nm et au-delà, la gravure plasma demande aussi généralement l'utilisation d'un masque dur métallique en lieu et place des résines organiques utilisées par la photolithographie classique notamment parce que la sélectivité à la gravure vis-à-vis du p-SiOCH est insuffisante, en raison des faibles épaisseurs de résine qu'il faut pouvoir utiliser pour définir des motifs de tailles décananométriques.

L'emploi d'un matériau poreux comme le SiOCH est donc souvent combiné avec l'utilisation d'un masque dur métallique ce qui ne manque pas cependant de créer d'autre problèmes qui sont exposés ci-après.

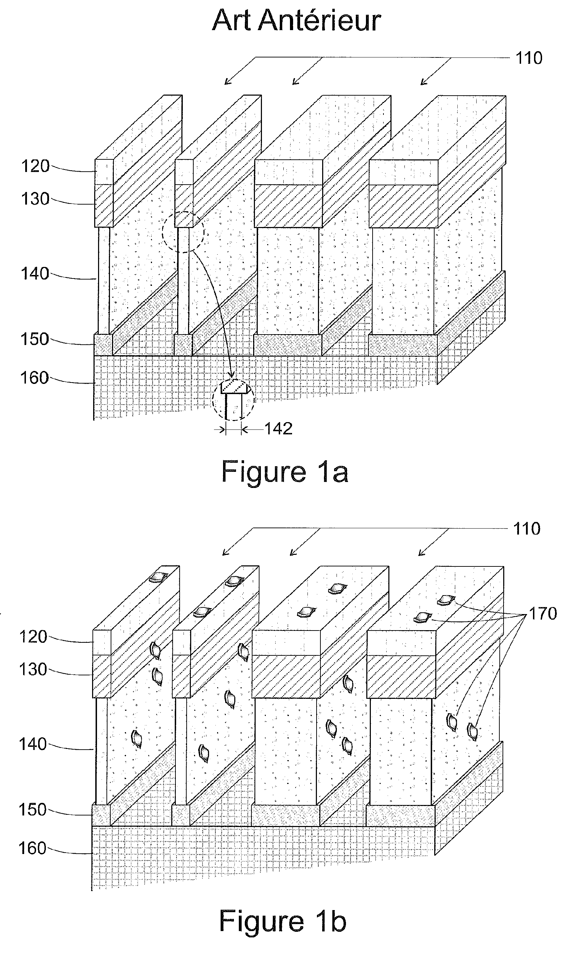

Les **figures 1a à 1e** illustrent les différents problèmes générés par la gravure du diélectrique poreux, le p-SiOCH, à partir d'un plasma fluorocarboné et l'utilisation d'un masque dur en nitrure de titane (TiN)

La **figure 1a** illustre la structure des lignes d'interconnexion après gravure dans un plasma fluorocarboné du matériau poreux utilisé comme diélectrique, le p-SiOCH, et avant remplissage des tranchées 110, comme cela est mis en oeuvre dans le procédé conventionnel dit damascène de formation des interconnexions en cuivre.

Comme mentionné précédemment, la gravure se fait en utilisant un masque dur 120, typiquement fait de nitrure de titane (TiN), qui recouvre une couche 130 d'oxyde de silicium (SiO₂) servant de couche d'arrêt pour l'étape de polissage mécano chimique (CMP) lors de la formation ultérieure des interconnexions en cuivre avec le procédé damascène. Sous la couche du matériau diélectrique poreux, le SiOCH 140, on trouve une couche 150 servant d'arrêt lors de la gravure plasma. La couche globale 160 symbolise toutes les couches sous jacentes du circuit intégré, notamment celles contenant les composants actifs qui sont réalisés lors des étapes préliminaires du procédé, celles qui précèdent les opérations dites « BEOL » acronyme de l'anglais « back-end of line » ou étapes de « fin de ligne » au cours desquelles on réalise, à des températures relativement faibles, tous les niveaux d'interconnexions entre les composants actifs et où l'on va graver successivement toutes les couches diélectriques.

La figure 1a illustre un premier problème lié à la plus grande sensibilité du matériau poreux lors de la gravure conventionnelle dans un plasma fluorocarboné. Une consommation plus importante du matériau poreux est observée correspondant à une surgravure 142 de cette couche. Par ailleurs, il y a absorption d'humidité (non représentée) qui accroît la constante diélectrique ce qui va à l'encontre du but recherché et affecte aussi la fiabilité du dispositif produit.

La **figure 1b** illustre un deuxième problème qui a trait à l'utilisation d'un masque dur métallique. Après que les tranches ont été gravées elles sont exposées à l'air libre et on constate la croissance de résidus 170. La croissance de ces résidus est d'autant plus forte que les tranches sont laissées plus longtemps à l'air libre. Le mécanisme de formation des résidus est attribué aux espèces fluorées présentes sur le masque dur en métal et sur les surfaces du matériau poreux à faible permittivité après qu'il a été gravé dans le plasma fluorocarboné. Les espèces fluorées réagissent alors à l'humidité de l'air produisant de l'acide fluorhydrique (HF) qui forme des sels métalliques avec le masque dur. Ces résidus affectent la qualité des dépôts suivants : celle de la couche faisant barrière à la diffusion du cuivre, et celle de la couche de cuivre qui va servir à former toutes les interconnexions métalliques (l'utilisation du cuivre requiert le dépôt préalable d'une couche destinée à empêcher la diffusion de ce dernier dans le matériau semi-conducteur servant à la réalisation des transistors, généralement du silicium). Ces résidus peuvent produire des vias intempestifs entre lignes (courts circuits) et des ruptures de lignes (circuits ouverts) qui affectent très significativement le rendement de fabrication des dispositifs produits.

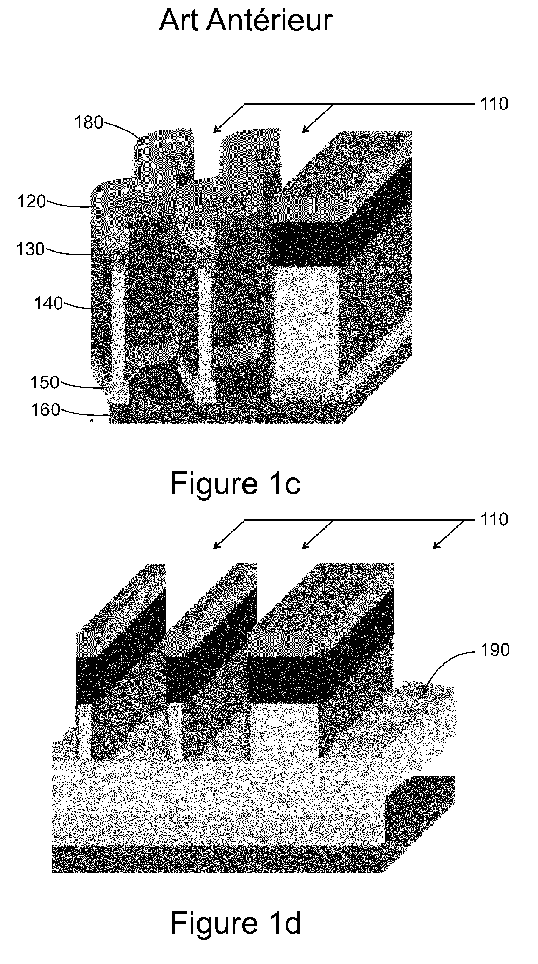

La **figure 1c** illustre un autre problème lié à l'utilisation d'un masque dur métallique. Avec la réduction constante des dimensions, les noeuds technologiques à partir de 45 nm, et ceux de tailles inférieures, mettent en évidence un problème d'ondulation 180 des lignes d'interconnexion les plus denses, c'est-à-dire là où il reste la largeur de matériau isolant la plus étroite entre les lignes. Le phénomène est créé lors de la gravure par le masque dur qui applique une compression résiduelle au matériau diélectrique poreux sous-jacent dont l'élasticité est limitée. On observe donc une déformation des lignes les plus denses sous la forme d'ondulations ou « wiggling ».

La **figure 1d** illustre encore un autre inconvénient résultant de l'utilisation d'un masque dur. Quand on augmente la porosité de la couche diélectrique 140 dans le but d'obtenir une constante diélectrique plus faible on constate aussi une augmentation corrélative de la rugosité 190 des fonds de lignes d'interconnexion après gravure. Cette rugosité des fonds de lignes, si elle n'affecte pas l'opération suivante de remplissage des tranchées par électromigration, dégrade cependant la fiabilité du dispositif produit en réduisant la durée de vie du diélectrique avant rupture qui est mesurée par l'intermédiaire d'un paramètre dit TDDB, acronyme de l'anglais « time-dependent dielectric breakdown » c'est-à-dire « rupture diélectrique dépendante du temps ». La rugosité observée est attribuée à la présence du masque dur en nitrure de titane (TiN) par l'intermédiaire d'un phénomène de micro masquage résultant de la condensation de composés fluorés non volatils de type TiFx provenant de la pulvérisation partielle du masque lors de la gravure dans le plasma fluorocarboné. La rugosité est également induite par le matériau poreux lui-même (p-SiOCH) qui peut se craqueler sous l'effet du plasma.

Par ailleurs, l'emploi d'un masque dur métallique a également un impact fort sur la stabilité du processus de gravure et sur sa reproductibilité. On observe, lors d'utilisations successives du réacteur plasma, une dérive des vitesses de gravure et de leur uniformité sur une tranche qui n'apparaît pas quand on utilise un masque dur organique traditionnel. On constate notamment une accumulation de composés à base de titane sur les parois et sur les électrodes supérieures du réacteur plasma qui conduit à un micro masquage de ces électrodes. Ces inconvénients sont qualifiés de « chamber defectivity » dans la littérature technique en anglais « défectivité dans la chambre de gravure ».

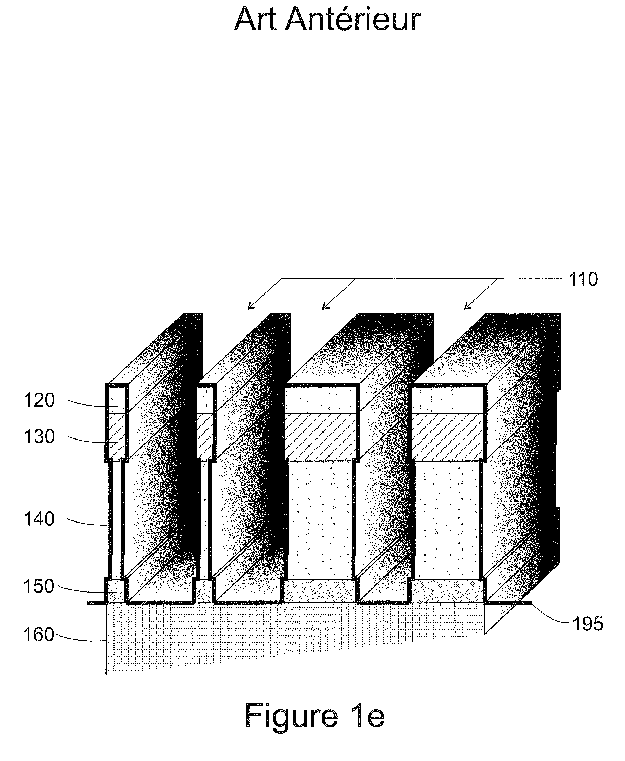

La **figure 1e** illustre encore un autre problème critique qui est lié au nettoyage par voie humide basé sur l'emploi d'acide fluorhydrique (HF) et qui s'avère n'être pas assez efficace pour éliminer toute la couche fluorocarbonée formée lors de la gravure. Après le nettoyage humide il reste du fluor sur les flancs. Il est encapsulé lors du dépôt de la barrière métallique 195 qui doit être déposé avant le dépôt de cuivre pour éviter la migration de ce dernier comme expliqué précédemment. Ce fluor peut conduire à une dégradation de fiabilité du film diélectrique poreux, le p-SiOCH. Un nettoyage humide agressif qui enlèverait toute la couche de fluor aurait l'inconvénient de conduire à une perte de définition des dimensions critiques (CD) des dispositifs fabriqués.

Par conséquent, en dépit de l'utilisation d'un masque dur, généralement un masque métallique fait de nitrure de titane (TiN), la mise en oeuvre de matériaux poreux à faible permittivité qui sont nécessaires pour réduire la constante de temps des interconnexions entre composants actifs d'un circuit intégré, et notamment leur gravure dans un plasma fluorocarboné, pose de nombreux problèmes.

La présente invention a pour objectif de limiter ou de supprimer au moins certains de ces problèmes.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

L'invention porte sur un procédé de gravure d'une couche de matériau diélectrique poreux. La gravure est réalisée dans un plasma à base de silicium de manière à faire croître tout au long de ladite gravure une couche de passivation, au moins sur les flancs de la couche de matériau diélectrique poreux. Tous les gaz à base de silicium peuvent être utilisés. Préférentiellement, tous les composés de type SixFy, SixCly et SixHy sont susceptibles de convenir. On pourra ainsi utiliser par exemple l'un des gaz suivants: tétrachlorure de silicium (SiCl₄), le tétrafluorure de silicium (SiF₄) ou le silane (SiH4), ou encore l'un des gaz suivants : Si2F6, Si3F8, Si2Cl6, Si2H4 et Si2H6. De préférence, pour les composés de type SixHy on se limitera aux composés dont le rapport x/y est supérieur ou égal à 0.3

Ainsi, la couche de passivation à base de silicium qui se développe pendant toute la gravure protége le matériau électrique poreux de toute contamination ou modification.

De manière préférée, le mélange de gaz formant le plasma comprend également de l'azote (N₂) et/ou de l'oxygène (O₂). La présence de l'azote et/ou de l'oxygène permet de renforcer la croissance de la couche de passivation sur les flancs.

Selon un autre mode de réalisation, l'invention porte sur un procédé de réalisation d'une interconnexion électrique. Le procédé comprend la gravure d'un motif formant une tranchée selon les étapes de l'invention. Il comprend de préférence également une étape ultérieure de remplissage de la tranchée par un matériau électriquement conducteur.

L'invention n'est cependant pas limitée à la réalisation des interconnexions entre les composants actifs d'un circuit intégré, c'est-à-dire les transistors. Elle convient chaque fois qu'il faut graver un matériau poreux de type SiOCH. Par exemple, les espaceurs de grille des transistors, qui sont actuellement réalisés en nitrure de silicium, peuvent aussi être faits de SIOCH poreux afin de réduire les capacités parasites entre la grille d'une part et les autres électrodes du transistor, c'est-à-dire source et drain.

Ainsi, selon un mode de réalisation non limitatif, le motif forme une tranchée et selon un autre mode de réalisation non limitatif, le motif peut servir à retirer la couche de matériau diélectrique poreux en dehors des flancs de la grille pour laisser en place des espaceurs.

Selon un autre mode de réalisation, l'invention porte sur un procédé de gravure d'une couche de matériau diélectrique poreux, dans lequel la gravure est réalisée dans un plasma à base de silicium en présence d'oxygène (02) et/ou d'azote (N2).

Selon une option, la gravure définit un motif dans une couche de matériau diélectrique poreux et comprend, préalablement à la gravure, la définition du motif dans un masque surmontant la couche de matériau diélectrique poreux, la gravure de la couche de matériau diélectrique poreux étant ensuite effectuée à travers le masque.

Selon un autre mode de réalisation, l'invention porte sur un procédé de gravure d'au moins un motif dans une couche de matériau diélectrique poreux. Le procédé comprend : la définition du motif dans un masque surmontant la couche de matériau diélectrique poreux; au moins une gravure de la couche de matériau diélectrique poreux à travers le masque. La gravure est réalisée dans un plasma comprenant un gaz à base de silicium et de l'azote (N₂) et/ou de l'oxygène (O₂) de manière à faire croître tout au long de ladite gravure une couche de passivation, au moins sur les flancs de la couche de matériau diélectrique poreux.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1e illustrent les différents problèmes générés par la gravure du diélectrique poreux, le p-SiOCH, à partir d'un plasma fluorocarboné et l'utilisation d'un masque dur en nitrure de titane (TiN).
La FIGURE 2 résume les étapes principales du procédé de l'invention et les différences d'avec le procédé standard de gravure du diélectrique poreux pour y former des tranchées.
Les FIGURE 3a à 3d illustrent les différentes étapes du procédé de l'invention.
Les FIGURES 4a à 4d illustrent une variante du procédé de l'invention qui permet d'obtenir une gravure plus abrupte des tranchées.
La FIGURE 5 illustre une autre variante du procédé de l'invention dans laquelle on n'utilise pas de masque dur métallique en nitrure de titane (TiN).

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

Il est précisé que dans le cadre de la présente invention, le terme « sur » « surmonte » ou « sous jacent » ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

On rappelle tout d'abord que l'invention porte sur un procédé de gravure d'une couche de matériau diélectrique poreux. La gravure est une gravure de type plasma. Le plasma est formé à partir d'un mélange de gaz contenant du silicium tels que par exemple le SixHy pour lesquels le rapport x/y est supérieur ou égal à 0.3, le SixFy ou le SixCly ou et plus généralement tous les gaz à base de silicium (Si), et contenant de préférence de l'azote (N₂) et/ou de l'oxygène (O₂) de manière à favoriser la croissance, tout au long de ladite gravure d'une couche de passivation.

Ainsi l'invention permet de graver le matériau diélectrique poreux sans recourir à un produit fluorocarboné.

Selon un mode de réalisation avantageux mais optionnel, le mélange de gaz comprend également de l'argon (Ar) ou de l'hélium (He) de manière à ce que la pente de la couche de passivation soit très inclinée, c'est-à-dire verticale ou proche de la verticale, ce qui est par exemple un avantage pour remplir les tranchées avec un matériau tel que le cuivre. Il s'est avéré que l'argon ou He, en jouant sur la dilution des espèces du plasma, permet de renforcer l'effet de ce gaz à base de Silicium sur la passivation des flancs.

Selon un mode de réalisation, la gravure est réalisée dans un plasma à base de silicium, et de préférence de tétrachlorure de silicium (SiCl4) ou de tétrafluorure de silicium (SiF4), en présence d'oxygène (02) combinés avec de l'argon (Ar) et la couche de passivation (112) est un oxyde de silicium (SiOx). Selon un autre mode de réalisation, la gravure est réalisée dans un plasma à base de silicium, et de préférence de tétrachlorure de silicium (SiCl4) ou de tétrafluorure de silicium (SiF4), en présence d'azote (N₂) combinés avec de l'argon (Ar) et la couche de passivation (112) est un nitrure de silicium (SiNxFy ou SiNxCly). Selon un autre mode de réalisation, la gravure est réalisée dans un plasma à base de silicium, et de préférence de tétrachlorure de silicium (SiCl4) ou de tétrafluorure de silicium (SiF4), en présence d'azote (N₂) et d'oxygène (02) combinés avec de l'argon (Ar) et la couche de passivation (112) est un oxy-nitrure de silicium (SiONxFy ou SiONxCly).

Selon un mode de réalisation, le gaz à base de silicium est pris parmi tous les composés de type SixHy pour lesquels le rapport x/y est supérieur ou égal à 0.3 et de préférence supérieur ou égal à 0.4 et de préférence supérieur ou égal à 0.5, tels que les Si2H4 et Si2H6 par exemple.

Dans le cadre du développement de la présente invention, il a été remarqué que ce rapport élevé permet d'améliorer la passivation des flancs et donc de protéger plus efficacement le matériau diélectrique poreux.

Selon un mode de réalisation, au cours de la gravure on maintient la température de la couche de matériau diélectrique poreux entre 10°C et 200°C. De préférence on maintient cette température entre 40°C et 100°C. Typiquement on agit sur un substrat sur lequel repose la couche de matériau diélectrique poreux pour maintenir la température de cette dernière. On peut ainsi maintenir la couche de matériau diélectrique poreux à la température ambiante, mais une température plus élevée est préférable.

Cette température permet de favoriser la volatilité des espèces (nitrure de titane par exemple) provenant du masque et qui sont volatilisées lors de la gravure. Or, dans le cadre du développement de la présente invention, il a été identifié que si ces espèces ne sont pas suffisamment volatiles, elles se redéposent alors sur le matériau diélectrique poreux à graver et empêchent alors localement que la gravure du matériau diélectrique poreux s'effectue correctement. Ces particules forment alors un micro masquage et entraine une dégradation de l'état de la surface du matériau à graver.

L'invention ne se place ainsi pas dans le cadre de la cryogénie qui requiert des chimies de gravures bien spécifiques et ne permet pas de recourir aux chimies employées avec des températures positives.

De manière avantageuse, mais non limitative, le motif est une tranchée.

Avantageusement, on effectue une étape d'enlèvement de la couche de passivation après gravure du matériau diélectrique poreux, l'étape d'enlèvement comprenant une étape de nettoyage par voie humide pour dissoudre entièrement la couche de passivation.

De préférence, le nettoyage par voie humide utilise une solution à base d'acide fluorhydrique (FH).

Avantageusement, le matériau diélectrique poreux est du SiOCH poreux. Plus généralement il s'agit d'oxydes dopés au carbone et à l'hydrogène pour former des matériaux de type dit silsesquioxane de formule (R-Si03/2)n. Le substituant -R peut être un groupe méthyle -CH3, on parle alors de méthyle silsesquioxane (MSQ), ou un atome hydrogène -H, on parle dans ce cas d'hydrogène silsesquioxane (HSQ).De préférence, la porosité du matériau diélectrique poreux est comprise entre 0% et 50% et de préférence entre 10% et 50%.

De manière avantageuse, on modifie les paramètres suivants pour ajuster l'inclinaison des flancs formés par la gravure dans la couche de matériau diélectrique poreux. Les paramètres permettant de jouer sur le profile sont la concentration en azote ou en oxygène du gaz et la température de la tranche. Par exemple, les espèces étant plus volatiles à haute température, plus la température de la tranche est élevée plus la couche de passivation obtenue est faible. Les flancs sont alors plus verticaux. Pour la concentration en azote et/ou en oxygène, un optimum est à trouver. Une faible concentration d'azote (N2) et/ou d'oxygène, inférieure à 30 sccm, ou une trop forte concentration, supérieure à 200 sccm, induisent une faible passivation et on court alors le risque d'obtenir un profile en forme de tonneau ou « bowing », terme anglais souvent utilisé pour qualifier ce type de profile. On notera ici qu'une faible quantité de H2 (0-50 sccm) peut être ajoutée au mélange SixFy/N2/Ar ou SixCly/N2/Ar afin de consommer le fluor ou le chlore permettant ainsi une plus grande polymérisation et l'obtention de profiles plus pentus. Cependant, l'ajout de H2, même en faible quantité, peut entraîner une modification importante du SiOCH poreux par diffusion d'espèces H à travers les pores. Celles-ci consomment alors les groupements méthyles ce qui entraîne une augmentation de la constante diélectrique et annihile le bénéfice attendu de la chimie de gravure de l'invention.

Ces paramètres permettent de contrôler l'inclinaison des flancs. Dans certains cas, notamment lorsque le diamètre ou la largeur du motif est petit, typiquement inférieur à 20 nm, il peut en effet être utile d'avoir des flancs légèrement inclinés, c'est-à-dire non verticaux. Cela permet d'éviter l'apparition de vide lors du remplissage du motif par un matériau tel que le cuivre. Typiquement, une pente comprise entre 80 et 89° et plus précisément entre 85 et 88° par rapport à l'horizontal peut être avantageuse pour favoriser le remplissage des motifs destinés à former des interconnexions.

Les paramètres ci-dessus permettent aussi d'ajuster l'épaisseur de la couche de passivation.

De manière avantageuse, on effectue plusieurs cycles comprenant chacun une gravure plasma de la couche du matériau diélectrique poreux et un enlèvement de la couche de passivation formée.

De manière avantageuse, une gravure de la couche du matériau diélectrique poreux réalisée par une succession de cycles de gravure-retrait de la couche de passivation permet d'obtenir des flancs plus abrupts.

De préférence, l'enlèvement de la couche de passivation formée à chaque cycle se fait par voie sèche en sublimant les espèces solides produites par la réaction de la couche de passivation à base de nitrure de silicium avec les produits de gravure générés par un plasma.

Selon une application avantageuse de l'invention, le procédé comprend, avant la gravure de la couche de matériau diélectrique poreux, la réalisation d'un masque surmontant la couche de matériau diélectrique poreux. Ce masque présente au moins un motif. La gravure de la couche de matériau diélectrique poreux est effectuée à travers le masque pour transférer le motif dans la couche de matériau diélectrique poreux.

Selon un mode de réalisation préféré, le masque dur est fait d'oxyde de silicium (SiO₂), de nitrure de silicium (SiN) ou de SiOCH dense. Un masque dur en résine organique peut également être envisagé.

Selon un mode de réalisation préféré, le matériau diélectrique poreux est du SiOCH poreux et le masque dur est fait d'oxyde de silicium (SiO₂), de nitrure de silicium (SiN) ou de SiOCH dense et a une épaisseur supérieure au cinquième de l'épaisseur de la couche du matériau diélectrique poreux. L'épaisseur pour chacune de ces couches est mesurée selon une direction perpendiculaire au plan dans lequel la couche de matériau diélectrique poreux s'étend. L'épaisseur de la couche du matériau diélectrique poreux se mesure entre une face inférieure de cette couche, cette face inférieure étant typiquement au contact d'une couche d'arrêt et la couche de protection.

De préférence, le masque dur présente une face inférieure au contact de la couche de matériau diélectrique poreux et une face supérieure opposée à la face inférieure. Ladite face supérieure est au contact de la solution de gravure lors de l'étape de gravure de la couche de matériau diélectrique poreux à travers le masque.

Ainsi, aucune autre couche ne recouvre le masque dur fait à base de silicium lors de la gravure. Ce mode de réalisation permet notamment de se passer d'un masque dur métallique, éliminant de ce fait les inconvénients induits par l'utilisation de ce type de masque. En outre ce mode de réalisation permet de réduire le nombre d'étapes de réalisation du motif, permettant ainsi d'augmenter la cadence de production et de diminuer les coûts.

De manière avantageuse, l'épaisseur du masque dur est adaptée pour ne pas être entièrement consommé pendant la gravure plasma de la couche de matériau diélectrique poreux.

Selon un autre mode de réalisation, le masque dur est un masque métallique de préférence en nitrure de titane (TiN).

Selon un mode de réalisation préféré, préalablement à la définition du motif dans le masque dur on dispose sous la couche de matériau diélectrique poreux une couche d'arrêt qui, lorsqu'elle est soumise au plasma utilisé pour graver la couche de matériau diélectrique poreux, présente une vitesse de gravure inférieure à la vitesse de gravure de la couche de matériau diélectrique poreux. On grave la couche d'arrêt à la suite de la gravure de la couche de matériau diélectrique poreux en utilisant ledit plasma. Le procédé est ainsi simplifié, le nombre d'étapes est réduit tout en contrôlant la gravure de la couche de matériau diélectrique poreux. Typiquement, l'arrêt de la gravure de la couche d'arrêt s'effectue au temps.

Selon un mode de réalisation préféré, on dispose au préalable sous la couche de matériau diélectrique poreux une couche d'arrêt conformée pour stopper la gravure de la couche de matériau diélectrique poreux, et on effectue après l'étape de gravure de la couche de matériau diélectrique poreux et avant l'étape d'enlèvement de la couche de passivation, une étape de gravure de la couche d'arrêt. Selon un mode de réalisation particulier, cette couche d'arrêt peut se graver avec la même chimie que celle utilisée pour graver le matériau diélectrique poreux.

De manière particulièrement avantageuse, la couche d'arrêt est également conformée pour empêcher la contamination de la couche de matériau diélectrique poreux par les couches sous jacentes.

La couche d'arrêt est par exemple en SiCH, en SiN ou en SiCN.

Selon un mode de réalisation préféré, le motif est une tranchée et le procédé comprend une étape ultérieure de remplissage de la tranchée par un matériau électriquement conducteur. Selon un mode de réalisation, la tranchée forme une interconnexion électrique. Typiquement, la tranchée est remplie de cuivre.

Selon un autre mode de réalisation, avant l'étape de gravure, le matériau diélectrique poreux recouvre une grille d'un transistor. Il est déposé de manière uniforme sur la grille. De préférence, il est ensuite gravé de manière anisotrope selon une direction principale parallèle à des flancs de la grille de manière à ne subsister que sur les flancs de la grille. Le matériau diélectrique poreux forme ainsi des espaceurs pour la grille.

De manière préférée, le substrat ou empilement de couche présente une face supérieure directement au contact de la couche d'arrêt. La couche de matériau diélectrique poreux est directement au contact de la couche d'arrêt par sa face inférieure et directement au contact de la couche de protection formée typiquement par une couche d'oxyde de silicium (Si02), de nitrure de silicium (SiN) ou de SiOCH dense, c'est-à-dire non poreux. Dans le cas où la structure comporte un masque métallique, ce dernier est de préférence directement au contact de ladite couche de protection.

Le plasma est exempt de produits fluorocarbonés.

Comme présenté dans le chapitre sur l'état de la technique, les inconvénients liés à l'utilisation du procédé traditionnel de gravure dans le cas de l'emploi d'un diélectrique poreux, du type SiOCH et d'un masque dur métallique fait de nitrure de titane (TiN) sont nombreux :
- Pour ceux liés à l'emploi d'un matériau diélectrique poreux, on notera que le matériau est alors sensible aux espèces réactives du plasma au cours de la gravure. Il y a modification du film avec consommation du matériau et absorption d'humidité ce qui entraîne une augmentation de la constante diélectrique et va à l'encontre du but recherché. Par ailleurs, le film diélectrique poreux est gravé dans un plasma fluorocarboné (CF) et il devient difficile d'enlever complètement le fluor restant à l'aide d'un nettoyage humide à base d'acide fluorhydrique (HF) sans dégrader le film diélectrique. La fiabilité du dispositif en est affectée.
- Pour ceux liés à l'usage d'un masque dur métallique, on observe la formation de résidus après la gravure et exposition à l'air ambiant qui entraîne une baisse du rendement de fabrication, une ondulation (wiggling) des lignes d'interconnexion les plus denses et des défauts liés à la chambre de confinement du réacteur plasma (chamber défectivity) qui entraînent aussi une perte de rendement.

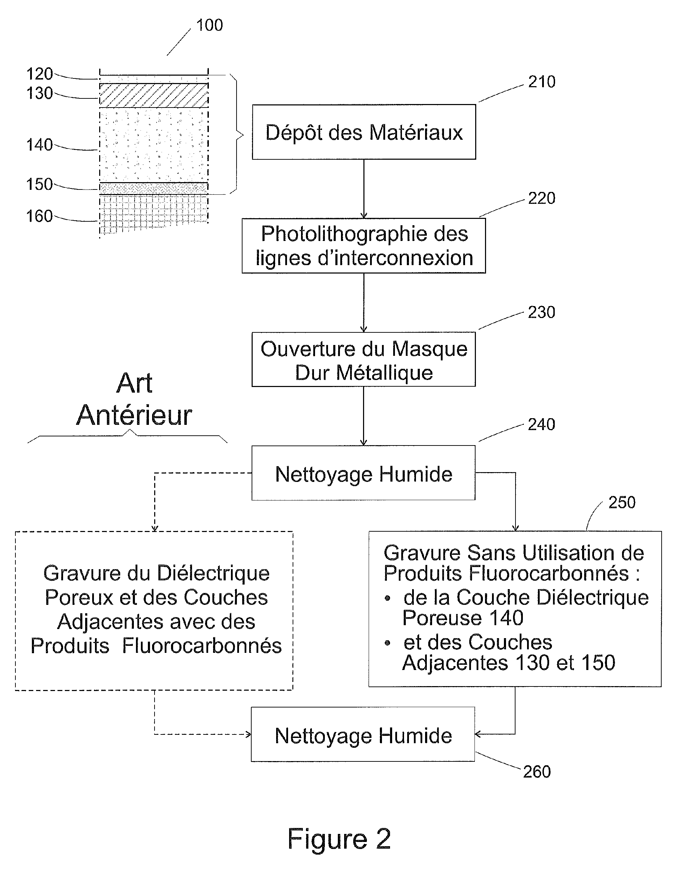

La figure 2 résume les étapes de gravure du diélectrique poreux selon le procédé de l'invention et souligne les différences d'avec le procédé standard.

On procède tout d'abord au dépôt 210 des différentes couches de matériaux incluant la couche diélectrique poreuse dans laquelle on va graver les lignes d'interconnexion. On retrouve les différentes couches déjà décrites qui sont, dans l'ordre où elles sont déposées : la couche d'arrêt à la gravure 150 ; le matériau diélectrique poreux 140 ; la couche d'oxyde 130 ; le masque dur métallique 120. Dans cette structure stratifiée 100 la couche globale 160 ou empilement de couches symbolise, comme on l'a déjà vu, l'ensemble des couches sous jacentes dans lesquelles on a déjà réalisé les composants actifs c'est-à-dire les transistors.

De manière avantageuse mais non limitative, les épaisseurs et matériaux des couches ci-dessus sont :
- Le masque dur métallique 120 est typiquement fait, comme on l'a vu, de nitrure de silicium (TiN) et est compris dans une gamme d'épaisseur allant de 5 à 100 nm et de préférence de 10 à 50 nm. Dans le cadre de la présente invention, le masque dur métallique 120 peut également être réalisé en nitrure de tantale (TaN) ou en nitrure de bore (BN).

La couche d'oxyde 130 est typiquement de l'oxyde de silicium (Si02) dans une gamme d'épaisseur allant de 10 à 50 nm. Elle sert, comme on l'a vu précédemment, de couche d'arrêt pour l'opération de polissage mécano chimique (CMP) qui est effectuée lors de la formation des interconnexions avec le procédé damascène.
- La couche 140 de diélectrique poreux est typiquement faite de SiOCH et son épaisseur comprise dans une gamme allant de 50 à 120 nm. Cette couche peut être déposée par centrifugation, opération qui est généralement qualifiée du terme anglais de « spin coating » c'est-à-dire dépôt par étalement à l'aide d'une « tournette ». Le dépôt de SiOCH se fait alors sous forme liquide sur la tranche en rotation et dans sa forme poreuse finale. On peut aussi procéder par voie sèche à un « dépôt chimique en phase vapeur assisté par plasma » ou PECVD, acronyme de l'anglais « plasma-enhanced chemical vapor déposition ». Le dépôt se fait alors en deux étapes à partir de deux gaz précurseurs. L'un pour générer la matrice dense de SiOCH, l'autre pour former la structure porogène dans laquelle on peut faire varier la proportion volumique de pores. Dans les deux cas la porosité du diélectrique est de préférence supérieure à 15% pour garantir une bonne efficacité de la gravure. Elle est typiquement comprise entre 15% et 50% et plus généralement comprise entre 0% et 50%.

La chimie de gravure de l'invention n'est pas limitée au SiOCH. Elle peut se pratiquer aussi avec d'autres matériaux tels que l'oxyde de silicium (Si02) et le nitrure de silicium (SiN).
- La couche 150 d'arrêt de la gravure est typiquement d'une épaisseur allant de 10 à 20 nm et peut être constituée des matériaux suivants utilisés de façon standard pour les opérations de fin de ligne de fabrication (BEOL). Il s'agit du carbure de silicium (SiCH), du nitrure de silicium (SiN) et du carbonitrure de silicium (SiCN). La couche d'arrêt joue avantageusement également un rôle de protection empêchant la contamination du matériau diélectrique poreux par des matériaux contaminants tel que le cuivre et qui sont présents dans les niveaux inférieurs 160.

L'étape suivante 220 consiste à définir par photolithographie classique, en utilisant une résine photosensible, les motifs des lignes d'interconnexions qui vont devoir être gravés dans la couche diélectrique poreuse. Pour ce faire on a recours à un masque dur métallique et les motifs ci-dessus sont donc d'abord transférés dans la couche 120 généralement faite de nitrure de titane (TiN). Les motifs définit dans la couche de résine (non représentée) sont donc ouverts à l'étape suivante 230 dans cette couche. Comme cela sera expliqué plus en détail par la suite, l'utilisation d'un masque dur est optionnelle dans le cadre de la présente invention. Ces opérations sont suivies d'une étape de nettoyage par voie humide 240.

L'invention diffère essentiellement du procédé standard en ce que la gravure de la couche 130 faite de Si02, de la couche diélectrique 140 faite de SiOCH poreux et de la couche d'arrêt 150, qui est réalisée à l'étape suivante 250, se fait comme on va le voir ci-après sans mettre en oeuvre de produits fluorocarbonés.

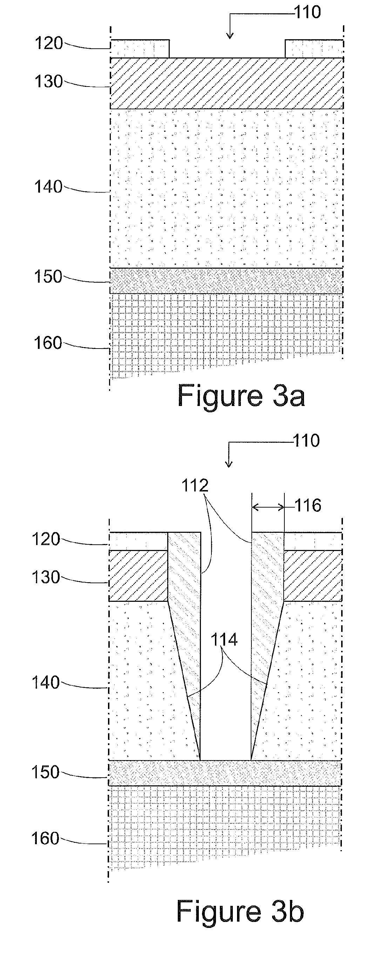

Dans les deux cas l'opération de gravure est suivie d'une nouvelle étape de nettoyage par voie humide 260. Les figures 3a à 3d détaillent les étapes du procédé de l'invention.

La **figure 3a** est une vue en coupe d'une ligne d'interconnexion 110 en formation après gravure du masque dur métallique 120. Le nitrure de titane (TiN) formant le masque dur est ouvert à l'aide d'une chimie à base de chlore (Cl₂) dans un appareillage dédié à la gravure du métal dans lequel on forme un plasma chloré.

La **figure 3b** illustre le résultat de l'étape de gravure de la couche Si02 130, de la couche diélectrique poreuse 140. Comme indiqué par la suite, la chimie de gravure de la couche Si02 130 et de la couche diélectrique poreuse 140 peut, selon un mode de réalisation particulier, également graver la couche d'arrêt 150. Contrairement au procédé conventionnel, avec l'invention on procède à la gravure de cette couche faite de SiOCH dans un plasma à base de silicium tel que le tétrachlorure de silicium (SiCl4) ou le tétrafluorure de silicium (SiF₄) en présence d'azote (N₂) combinés avec de l'argon (Ar). Comme on l'a vu précédemment tous les gaz à base de silicium (Si) tel que SixFy, SixCly, SixHy sont aussi susceptibles de convenir. Durant cette opération il y a formation d'une couche de passivation 112 sur les flancs de la tranchée La formation de la couche de passivation est favorisée par le fait que le bombardement sur les flancs des motifs est faible alors, qu'au contraire, sur le fond des motifs, le bombardement empêche la formation de cette couche.

Bien que, selon un mode de réalisation préférée, la chimie de gravure est la même pour les couches 140 et 150, la couche 150 fait tout de même office de couche d'arrêt. En effet la vitesse de gravure du matériau de la couche 150 est inférieure à celle du matériau de la couche 140, notamment du fait de la porosité de la couche 140.

La gravure du SiO2, du p-SiOCH et de la couche d'arrêt s'arrête sur la couche 160. En raison de la présence de la couche de passivation la gravure se fait sans aucune modification de la couche diélectrique poreuse. On emploie typiquement un graveur plasma de type ICP ou CCP. De manière avantageuse, on emploie le même équipement que pour la gravure des couches 130, 140 et 150. Les gammes de valeurs avantageuses des conditions de mise en oeuvre de cette gravure sont résumées dans le tableau ci-après, sans que l'invention se limite à ces valeurs:

| | |
|---|---|
| Puissance de la source : | 0-2000 Watts |
| Puissance bias (contrôle de l'énergie des ions) | 0-300 Watts |
| Débits SiH4, SiCl₄ ou SiF4 : | 10-200 sccm (centimètres cube par minute dans des conditions standard de pression et de température) |
| Débits N₂ : | 10-200 sccm |
| Débit 02 (peut être ajouté avec l'azote ou utilisé seul pour jouer sur la pente) | 1-50 sccm |
| Débit Ar ou He : | 50-1000 sccm |
| Puissance de polarisation : | 50-2000 Watts |
| Pression : | 5-100 milliTorr |
| Température : | 10-100 °C |
| Temps : | quelques secondes à quelques centaines de secondes |

Cette gamme de températures permet de favoriser la volatilité des espèces pulvérisées du masque et d'éviter leur re-dépôt sur le diélectrique poreux. On limite voire on supprime les risques de micro masquage et on améliore ainsi l'état de la surface et la précision de la gravure.

La gravure de la couche diélectrique repose sur le fait que le SiOCH poreux est gravé par le bombardement des ions générés par le plasma tandis qu'une couche de passivation 112 faite d'une forme de nitrure de silicium (SiNxFy ou SiNxCly ou SiNxHy) ou d'oxyde de silicium (SiOx) se crée spontanément sur les flancs comme expliqué ci-dessus. La formation de la couche de passivation se fait avec une modification limitée du matériau constituant la couche diélectrique poreuse.

L'épaisseur de la couche de passivation, qui croît durant toute la gravure du SiOCH, permet de jouer sur l'inclinaison 114 des flancs de la tranchée 110. L'épaisseur 116 de la couche de passivation, qui est typiquement comprise dans une plage de valeurs allant de 1 à 5 nm, peut être ajustée en jouant sur les paramètres du plasma durant la gravure.

L'inclinaison des flancs de la tranchée favorise, lors des opérations de fin de ligne (BEOL), l'obtention d'un dépôt satisfaisant, d'une part, de la couche faisant barrière à la diffusion du métal, c'est-à-dire la couche 195 représentée sur la figure 1e, et d'autre part, de la couche de cuivre destinée à remplir les tranchées pour former les interconnexions.

Par exemple, pour obtenir une couche de passivation dont l'épaisseur 116 est de 5 nm, les conditions peuvent être dans un réacteur CCP : débit de tétrafluorure de silicium (SiF₄) de 90 sccm ; débit d'Azote (N₂) de 150 sccm ; débit d'argon (Ar) de 600 sccm; pression de 12 mTorr ; puissance bias (permettant de contrôler l'énergie des ions) 50 watts, puissance source 150 Watts, température de la tranche 65°C.

Les paramètres importants contrôlant la formation de la couche de passivation sont le rapport SiF4/N2 et la puissance source et la puissance bias qui permettent de contrôler le taux de dissociation et l'énergie des ions, respectivement, dans un réacteur CCP.

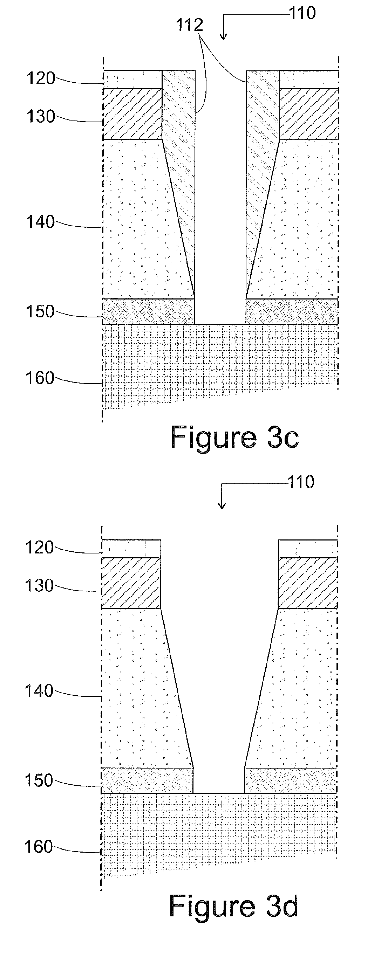

La **figure 3c** montre le résultat de la gravure de la couche d'arrêt 150 faite, comme on l'a vu, de carbure de silicium (SiCH), de nitrure de silicium (SiN) ou de carbonitrure de silicium (SiCN). Dans un mode de réalisation préféré, la gravure de cette couche 150 se fait à l'aide de la même chimie de gravure qui est utilisée pour le SiOCH poreux. Dans ce mode de réalisation, la fin de la gravure ne s'arrêterait alors pas sur la face supérieure de la couche d'arrêt 150 comme illustré en figure 3b mais sur la face supérieure de la couche 160 comme illustré en figure 3c.

La gravure de la couche 150 est effectuée dans le même graveur plasma. La couche de p-SiOCH est dans ce cas toujours protégée de toute contamination par la couche de passivation 112 qui a été formée lors de l'étape de gravure précédente. Elle n'est donc pas altérée comme dans le procédé conventionnel.

La **figure 3d** illustre le résultat de l'opération suivante où l'on pratique un nouveau nettoyage humide 260 qui sert notamment à enlever la couche de passivation devenue inutile. Comme déjà mentionné, les nettoyages humides se font à partir de solutions à base d'acide fluorhydrique (HF). L'enlèvement de la couche de passivation peut se faire par exemple dans une solution d'acide fluorhydrique à 1%. En fonction de l'épaisseur de la couche à enlever l'opération peut durer de quelques secondes à quelques minutes. Dans une solution à 1 % l'enlèvement de la couche de passivation prend typiquement de l'ordre de 30 secondes.

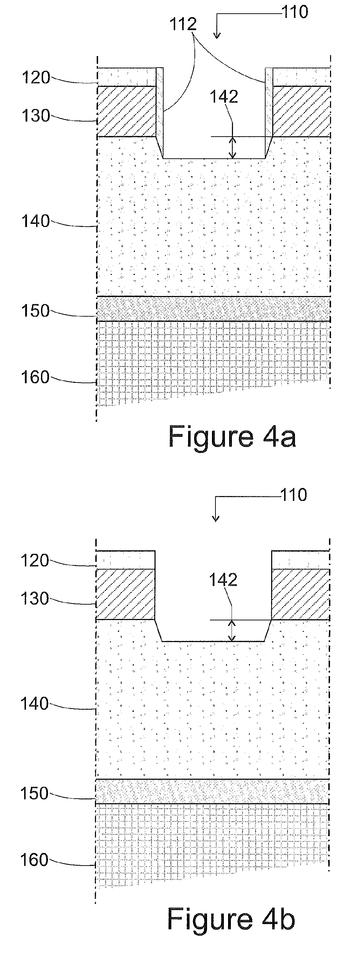

Les **figures 4a à 4d** décrivent une variante du procédé de l'invention avec laquelle on obtient des flancs 114 de tranchées 110 plus abruptes. Pour ce faire, la gravure est effectuée en autant de cycles que nécessaires pour satisfaire les spécifications de l'application considérée.

La **figure 4a** illustre le résultat d'un premier cycle de gravure partielle 142 de la couche 140. La gravure partielle de la couche diélectrique est effectuée pendant un temps court, typiquement pendant quelques secondes, dans les mêmes conditions que celles décrites dans la figure 3b. Il y a début de formation d'une couche de passivation 112.

La **figure 4b** montre l'enlèvement de la couche de passivation qui est pratiquée cette fois à l'aide d'un nettoyage par voie sèche qui peut se pratiquer dans le même équipement. Le retrait par voie sèche de la couche de passivation faite de SiNx utilise de préférence une méthode qui est décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993. Quoique décrite pour l'oxyde de silicium, il s'est avéré que cette méthode s'adapte aussi au nitrure de silicium. Le mécanisme est identique et comprend les étapes suivantes qui s'effectuent dans une chambre de réaction où l'on forme un plasma. Une première étape consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃). La gravure se fait au cours d'une deuxième étape, à une température de l'ordre de 30°C et plus généralement entre 10°C et 50°C, sous la forme d'une formation de sels selon la réaction chimique suivante entre le nitrure de silicium et le produit de gravure généré par le plasma:

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Les espèces solides qui sont formées au cours de cette opération sont ensuite sublimées à une température supérieure à 100°C pendant quelques dizaines de secondes selon la réaction suivante :

(NH₄)2SiF₆ (solid) → SiF₄(g) + NH₃(g) + HF(g)

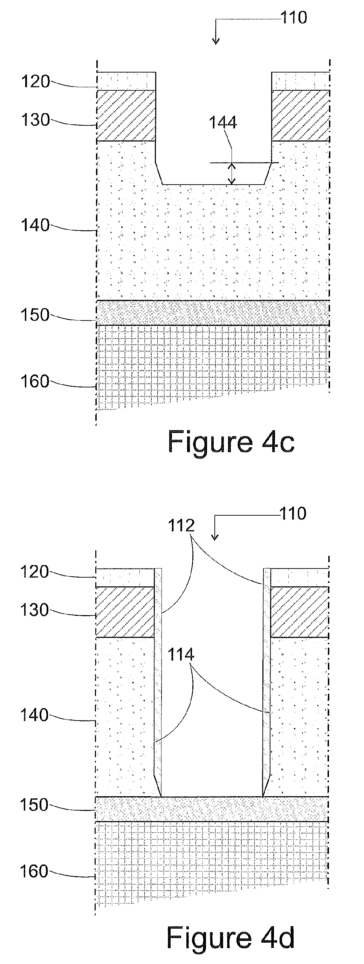

La **figure 4c** montre le résultat d'un deuxième cycle de gravure 144 et d'enlèvement, à l'aide d'un nettoyage par voie sèche comme ci-dessus, de la couche de passivation qui s'était reformée lors de la gravure.

La **figure 4d** montre le résultat final de la gravure après que suffisamment de cycles de gravure partielle et d'enlèvement de la couche de passivation par voie sèche ont été exécutés. Lors du dernier cycle on laisse en place la couche de passivation 112 qui va servir à protéger les flancs 114 de la tranchée 110 creusée dans le diélectrique poreux pendant l'opération d'ouverture de la couche d'arrêt de la gravure 150. Après quoi la couche sera enlevée par voie humide comme décrit dans la figure 3d.

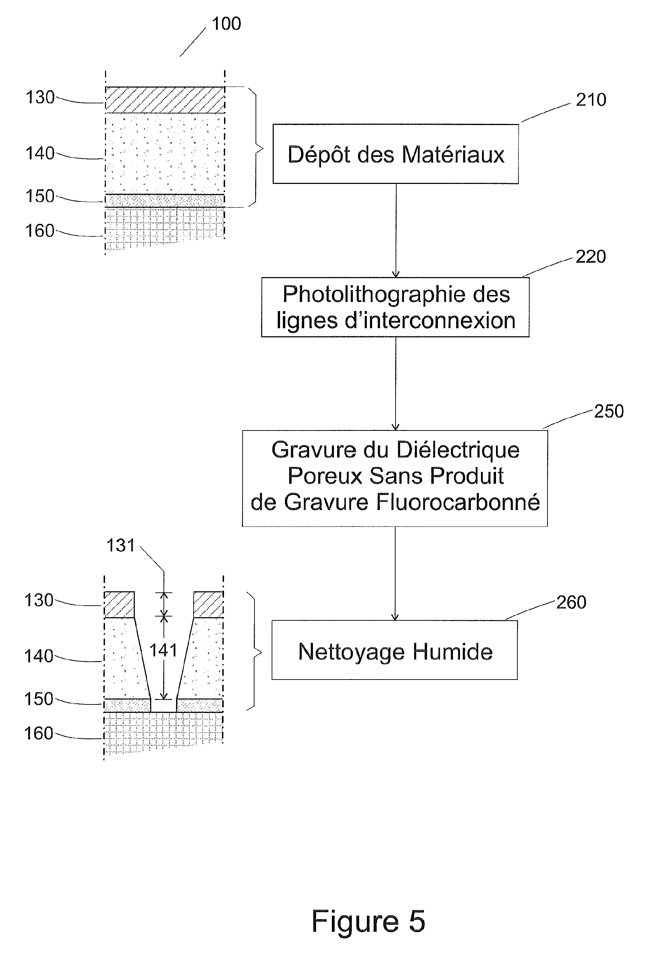

La **figure 5** montre les étapes d'une autre variante du procédé de l'invention dans laquelle on n'utilise pas de masque dur métallique et où les étapes 230 et 240 ont été supprimées. La structure stratifiée 100 qui est déposée à l'étape 210 ne comprend donc plus la couche 120 de nitrure de titane (TiN). C'est la couche 130 d'oxyde de silicium qui va alors servir de masque dur. Dans cette variante du procédé les conditions de gravure du p-SiOCH sont les mêmes qu'avec le masque dur métallique et comme décrites dans la figure 3b. Toutefois, le différentiel de gravure entre le SiO₂ et le p-SiOCH étant moins grand qu'entre le TiN et le p-SiOCH il faut prévoir une consommation de SiO₂ plus importante pendant la gravure et respecter un rapport minimum entre l'épaisseur 141 de la couche à graver et l'épaisseur 131 de la couche d'oxyde. Typiquement, l'épaisseur de la couche d'oxyde sera supérieure au 1/5 de celle de la couche de p-SiOCH. L'épaisseur pour chacune de ces couches est mesurée selon une direction perpendiculaire au plan dans lequel les couches 134, 140, 160 s'étendent. Dans cette variante du procédé la couche 130, qui sert de masque dur, peut aussi être faite de nitrure de silicium (SiN) ou de SiOCH dense (non poreux).

En résumé, d'une part, le remplacement de la gravure traditionnelle du pSiOCH par une gravure non fluorocarbonée fait qu'il n'y a pas modification du matériau des flancs des tranchées pendant la gravure et pas de résidus fluorés qui empêchent que l'opération de nettoyage humide puisse s'effectuer efficacement comme on la vu dans la figure 1e. Ces deux problèmes concourent à une baisse de fiabilité des dispositifs produits avec le procédé standard. Au contraire, dans le cas de l'invention la couche de passivation faite de SiOx ou de SiNx protège le diélectrique poreux pendant toute la gravure et s'enlève complètement ensuite à l'aide d'un nettoyage humide.

D'autre part, la variante du procédé décrite dans la figure 5 permet de s'affranchir de l'utilisation d'un masque dur métallique en TiN et donc des nombreux problèmes associés qui ont été décrits dans les figures 1b, 1c et 1d. Le procédé ainsi simplifié se traduit par une meilleure productivité et un coût moindre.

## Revendications

1. Procédé de gravure d'une couche de matériau diélectrique poreux (140), **caractérisé en ce que** la gravure est réalisée dans un plasma formé au moins d'un gaz à base de silicium mélangé à de l'oxygène (O₂) et/ou à de l'azote (N₂) de manière à faire croître tout au long de ladite gravure une couche de passivation (112), au moins sur des flancs de la couche de matériau diélectrique poreux (140) et **en ce que** le gaz à base de silicium est pris parmi tous les composés de type SixHy pour lesquels le rapport x/y est supérieur ou égal à 0.3 et parmi tous les composés de type SixFy ou SixCly, où x est la proportion de silicium (Si) dans le gaz et où y est la proportion d'hydrogène (H) ou de chlore (CI) ou de fluor (F) dans le gaz.

2. Procédé selon la revendication 1 dans lequel le gaz à base de silicium est pris parmi le tétrachlorure de silicium (SiCl4) ou le tétrafluorure de silicium (SiF₄).

3. Procédé selon l'une quelconque des revendications précédentes dans lequel le plasma comprend également de l'argon (Ar) ou de l'hélium (He).

4. Procédé selon la revendication 1 dans lequel la gravure est réalisée dans un plasma à base de silicium, et de préférence de tétrachlorure de silicium (SiCl4) ou de tétrafluorure de silicium (SiF4), en présence d'oxygène (02) combinés avec de l'argon (Ar) et la couche de passivation (112) est un oxyde de silicium (SiOx).

5. Procédé selon la revendication 1 dans lequel la gravure est réalisée dans un plasma à base de silicium, et de préférence de tétrachlorure de silicium (SiCl4) ou de tétrafluorure de silicium (SiF4), en présence d'azote (N₂) combinés avec de l'argon (Ar) et la couche de passivation (112) est un nitrure de silicium (SiNxFy ou SiNxCly).

6. Procédé selon la revendication 1 dans lequel la gravure est réalisée dans un plasma à base de silicium, et de préférence de tétrachlorure de silicium (SiCl4) ou de tétrafluorure de silicium (SiF4), en présence d'azote (N₂) et d'oxygène (02) combinés avec de l'argon (Ar) et la couche de passivation (112) est un oxy-nitrure de silicium (SiONxFy ou SiONxCly).

7. Procédé selon l'une quelconque des revendications précédentes dans lequel au cours de la gravure on maintient la température de la couche de matériau diélectrique poreux (140) entre 10°C et 200°C et de préférence entre 40°C et 100°C.

8. Procédé selon l'une quelconque des revendications précédentes dans lequel on modifie au moins l'un des paramètres suivants pour ajuster l'inclinaison des flancs de la couche de matériau diélectrique poreux (140) formés par la gravure de la couche de matériau diélectrique poreux (140) et/ou pour ajuster l'épaisseur de la couche de passivation :
- la concentration en azote et/ou en oxygène du gaz formant le plasma,
- la température de l'empilement de couche comprenant le matériau diélectrique poreux (140).

9. Procédé selon l'une quelconque des revendications précédentes dans lequel on effectue une étape d'enlèvement de la couche de passivation (112) après gravure du matériau diélectrique poreux (140), l'étape d'enlèvement comprenant une étape de nettoyage par voie humide pour dissoudre entièrement la couche de passivation (112).

10. Procédé selon la revendication précédente dans lequel le nettoyage par voie humide utilise une solution à base d'acide fluorhydrique (FH).

11. Procédé selon l'une quelconque des revendications précédentes dans lequel le matériau diélectrique poreux (140) est un silsesquioxane de formule (R-Si03/2)n, -R étant un groupe méthyle -CH3 ou un atome hydrogène -H.

12. Procédé selon l'une quelconque des revendications précédentes dans lequel le matériau diélectrique poreux (140) est un oxyde de silicium dopé au carbone et à l'hydrogène (SiOCH) poreux.

13. Procédé selon l'une des revendications précédentes dans lequel on effectue plusieurs cycles comprenant chacun une gravure plasma (142, 144) de la couche du matériau diélectrique poreux (140) et un enlèvement de la couche de passivation (112) formée.

14. Procédé selon la revendication précédente dans lequel l'enlèvement de la couche de passivation (112) formée à chaque cycle se fait par voie sèche en sublimant les espèces solides produites par la réaction de la couche de passivation à base de nitrure de silicium avec les produits de gravure générés par un plasma.

15. Procédé selon l'une quelconque des revendications précédentes comprenant, avant la gravure de la couche de matériau diélectrique poreux (140), la réalisation d'un masque (120, 130) surmontant la couche de matériau diélectrique poreux (140), le masque présentant au moins un motif et la gravure de la couche de matériau diélectrique poreux (140) étant effectuée à travers le masque (120, 130) pour transférer le motif dans la couche de matériau diélectrique poreux (140).

16. Procédé selon la revendication précédente dans lequel le masque dur (130) est fait d'oxyde de silicium (SiO₂), de nitrure de silicium (SiN) ou de SiOCH dense.

17. Procédé selon l'une quelconque des revendications 1 à 14 dans lequel, avant l'étape de gravure, le matériau diélectrique poreux (140) recouvre une grille d'un transistor et dans lequel la gravure est effectuée de manière anisotrope selon une direction principale parallèle à des flancs de la grille, de sorte à retirer la couche de matériau diélectrique poreux (140) uniquement en dehors de flancs du transistor pour former des espaceurs pour la grille.
